(19)

Europäisches Patentamt

European Patent Office

Office européen des brevets

(11) **EP 4 750 301 A2**

(12) **EUROPEAN PATENT APPLICATION**

(43) Date of publication:
**27.05.2026 Bulletin 2026/22**

(21) Application number: **25315380.3**

(22) Date of filing: **06.11.2025**

(51) International Patent Classification (IPC):
$H10N\ 70/00^{(2023.01)}$        $H10B\ 63/10^{(2023.01)}$

(52) Cooperative Patent Classification (CPC):
**H10N 70/8413; H10B 63/10; H10B 63/30;
H10N 70/011; H10N 70/231; H10N 70/826;
H10N 70/8828**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.11.2024 US 202418958125**

(71) Applicant: **STMicroelectronics International N.V.
1228 Plan-les-Ouates, Geneva (CH)**

(72) Inventors:
- **Turconi, Lorenzo
  20854 Agrate Brianza (MB) (IT)**
- **Petroni, Elisa
  20854 Agrate Brianza (MB) (IT)**
- **Le Friec, Yannick
  38570 Goncelin (FR)**
- **Redaelli, Andrea
  20854 Agrate Brianza (MB) (IT)**

(74) Representative: **Studio Torta S.p.A.
Via Viotti, 9
10121 Torino (IT)**

(54) **PHASE CHANGE MEMORY CELL HAVING A HEATER WITH ACTIVATED RESISTANCE IN TEMPERATURE, AND IN-MEMORY COMPUTATION CIRCUIT USING SUCH A PHASE CHANGE MEMORY CELL**

(57)     A phase change memory (PCM) cell includes a phase change material region and a heater element coupled to phase change material region. The heater element is made of an electrically conductive material having an activated resistance in temperature property. The electrically conductive material of the heater element is an alloy having a silicon content in a range of 14-19%. The alloy for the conductive material of the heater element is deposited by an atomic layer deposition process in a conformal layer having a substantially constant thickness.

FIG. 2

EP 4 750 301 A2

**Description**

TECHNICAL FIELD

The present invention generally relates to a phase change memory (PCM) cell and, in particular, to the use of a heater element in the phase change memory cell made of an electrically conductive material having activated resistance in temperature. In this context, an electrically conductive material for the heater of the PCM cell exhibiting an "activated resistance in temperature" means that the electrically conductive material has a first resistance range at a low temperature (associated with reading the PCM cell) and a second resistance range, less than the first resistance range, at a high temperature (associated with programming the PCM cell).
One or more embodiments can be applied to an in-memory computation (IMC) circuit including a memory array using such a phase change memory cell.

BACKGROUND

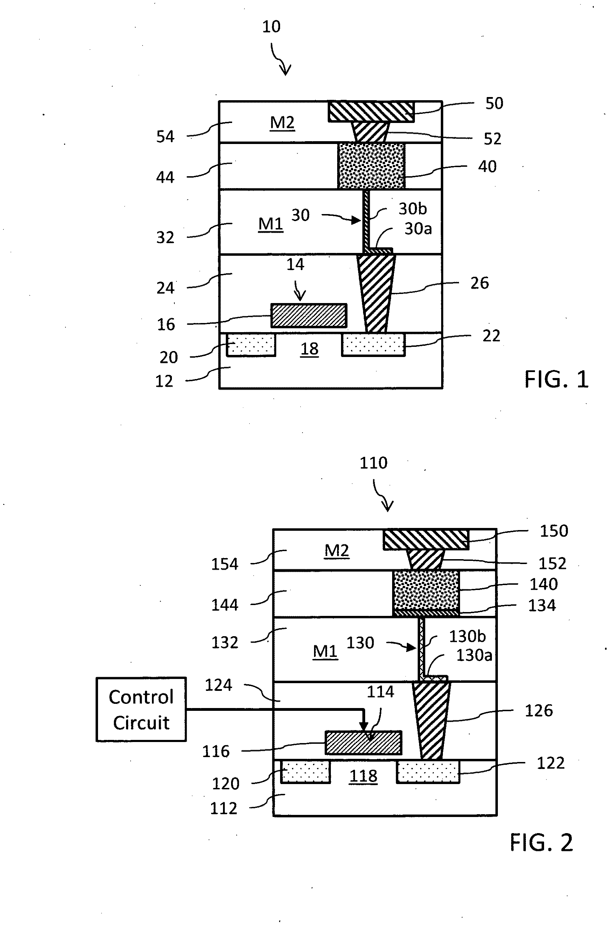

A phase change memory (PCM) device uses a phase change material for an electronic memory data storage application. A phase change material is a material that can be electrically switched between a generally amorphous state and a generally crystalline state, or between different detectable states of local order across an entire spectrum between completely amorphous and completely crystalline states. The state of the phase change material is also non-volatile in that, once set by a programming operation in either a crystalline, semi-crystalline, amorphous, or semi-amorphous state representing a desired resistance value associated with a data value, that resistance value is retained until changed by another programming event, as that resistance value represents a phase or physical state of the material (e.g., from crystalline to amorphous). The state is unaffected by removing electrical power and thus the memory can be considered as non-volatile.
It is well known in the art to use alloys of group VI elements of the periodic table, such as tellurium (Te) or selenium (Se), referred to as chalcogenides or chalcogenic materials, as phase change materials in a phase change memory cell. One commonly used chalcogenide is formed by a germanium (Ge), Antimony (Sb) and Tellurium alloy ($Ge_2Sb_2Te_5$) which is referred to in the art as the GST 225 alloy. It is also known in the art to dope the GST 225 alloy with impurities to obtain higher crystallization temperatures wherein needed. Additionally, it is known to use Ge-enriched alloys (i.e., alloys having a higher Ge content or in which Ge is a predominant component of the average composition). Examples such Ge-rich chalcogenides include $Ge_4Sb_4Te_7$ (referred to as the GST 447 alloy) and $Ge_7Sb_1Te_2$ (referred to as the GST 712 alloy).
The resistivity of chalcogenides typically varies by two or more orders of magnitude when the material passes from the amorphous phase (more resistive) to the polycrystalline phase (more conductive) and vice versa.
A phase change is typically obtained by locally increasing a temperature of the chalcogenide phase change material. Below a temperature of 150°C all phases are stable, and it is in this temperature range where read operations on the PCM cell are performed. Above a temperature of 200°C (referred to as the temperature of start of nucleation), fast nucleation of the crystallites takes place, and the chalcogenide material changes its phase and becomes crystalline (the so-called set state) if the material is kept at this crystallization temperature for a sufficient length of time, and it is in this temperature range where programming (data write) operations on the PCM cell are performed. To bring the chalcogenide material to the amorphous state (the so-called reset state), it is necessary to raise the temperature of the chalcogenide material above the melting temperature (approximately 600°C) and then perform a rapid cool off. Intermediate phases between completely amorphous (reset) and completely crystalline (set) states can be obtained applying suitable temperatures for different lengths of time, which cause the formation of amorphous "spots" or "bubbles" of different dimensions in contact with the heater.
From an electrical standpoint, it is possible to cause the chalcogenic material to change state by causing a current to flow through a resistive element of the PCM cell, referred to as a heater element, which heats the chalcogenic material by the Joule effect.
Reference is made to Figure 1 showing the basic structure of a PCM cell 10 implemented in an integrated circuit. A semiconductor substrate 12 includes a transistor 14 comprised of an insulated gate 16 extending over a channel region 18 between a doped source region 20 and a doped drain region 22. The substrate 12 is covered by a layer 24 of dielectric material. A contact plug 26, for example, made of tungsten, extends through the layer 24 to make electrical connection to the drain region 22 (perhaps using a suitable silicide interface). A heater element 30 for the PCM cell 10 is provided in an insulating layer 32 extending over the layer 24. This insulating layer 32 is, for example, a part of a first metallization layer (M1) of the integrated circuit. The heater element 30 is made of an electrically conductive material (for example, titanium silicon nitride (TiSiN)) that is well suited to heat the chalcogenic material by the Joule effect in response to the flow of a programming current. The shape of the heater element, in cross section as shown, is in the form of an L-shape including a horizontal portion 30a in contact with the upper surface of the contact plug 26 and a vertical portion 30b extending through the insulating layer 32 (see, for example, United States Patent Nos. 10,510,955, 11,227,992 and 11,653,582, incorporated herein by reference). A region 40 of chalcogenic material is provided over the layer 32 and heater element 30 (specifically making contact with a distal end of the vertical portion 30b). The region 40 is surrounded, in a non-limiting example, by a layer 44 of insulating material. A second metallization layer (M2) of the integrated circuit includes a metal line 50 electrically connected to the region 40 of chalcogenic material by a via 52 within an insulating layer 54.

When reading the PCM cell, a current (much lower in amperage than the programming current) is passed through the region 40. The data value read from the PCM cell is dependent on the resistivity of the current path which is directly correlated to the programmed resistivity of the chalcogenic material. For example, the relatively lower resistivity associated with the crystalline phase of the chalcogenic material in region 40 is read as the set (or logic 1) data state, and the relatively higher resistivity associated with the amorphous phase of the chalcogenic material in region 40 is read as the reset (or logic 0) data state.

It is known in the art to utilize PCM cells in a memory array of an in-memory computation (IMC) circuit, such as for use in a neural network (NN). There is a recognized relationship between the throughput/power ratio of the PCM cell and the conductance of the low resistive state (LRS), also known as the set state, where the phase of chalcogenide material is more crystalline. Tera operations per second per Watt (TOPS/W) is generally used as a measure of the efficiency of the IMC circuit in neural network processing:

$$\frac{OPS}{W} = \frac{2 \cdot OP}{G_{SET} \cdot V_{read}^2 \cdot PW}$$

Where: OP is the number of operations, $G_{SET}$ is the conductance of the PCM cell in the low resistive state; V is the applied read voltage; and PW is the inference length of time.

It is accordingly noted that there is a performance advantage with higher TOPS/W to having a less conductive (i.e., a higher resistivity) set state for the PCM cell. One solution to provide such a less conductive set state is to dope the chalcogenide material of the PCM cell to limit conductivity in the crystalline phase. However, this solution has a known drawback on the stability (drift and noise) of the low resistive state.

There is a need in the art to provide a PCM cell for use in an IMC circuit that exhibits a lower conductivity in the set state while still permitting efficient operation of the PCM cell during programming operations.

SUMMARY

The invention is set out in the annexed claims.

In an example embodiment, a phase change memory (PCM) cell comprises: a phase change material region; and a heater element coupled to phase change material region; wherein the heater element comprises a layer of an electrically conductive material having an activated resistance in temperature property; and wherein the electrically conductive material of the heater element is an alloy having a silicon content in a range of 14-19%.

In an example embodiment, an in-memory computation (IMC) device comprises a memory array including a plurality of memory cells, wherein each memory cell of said plurality of memory cells is a PCM cell as described above.

In an example embodiment, a method of making a phase change memory (PCM) cell comprises: producing a heater element; and producing a phase change material region over the heater element; wherein producing the heater element comprises depositing by atomic layer deposition a conformal layer of an electrically conductive material having an activated resistance in temperature property; wherein the electrically conductive material of the heater element is an alloy having a silicon content in a range of 14-19%.

The activated resistance in temperature property means that the conductive material has a first resistance range when the conductive material is subjected to a temperature within a first temperature range and a second resistance range, lower than the first resistance range, when the conductive material is subjected to a temperature within a second temperature range higher than the first temperature range.

The conformal layer has a horizontal layer portion having a first thickness and a vertical layer portion having a second thickness, wherein the first and second thicknesses are substantially equal.

BRIEF DESCRIPTION OF THE DRAWINGS

For a better understanding of the embodiments, reference will now be made by way of example only to the accompanying figures in which:

Figure 1 shows the structure of a phase change memory (PCM) cell;
Figure 2 shows the structure of a PCM cell with a heater element having activated resistance in temperature;
Figure 3 shows a plot of resistivity versus temperature for conductive materials used for heater elements in the PCM cells of Figures 1 and 2;
Figure 4 shows a plot of conductance versus program current for the PCM cells of Figures 1 and 2;
Figure 5 shows a plot of program current versus program voltage for the PCM cells of Figures 1 and 2;
Figure 6 shows a basic block diagram for an in-memory computation (IMC) system; and
Figure 7 shows a schematic diagram of an in-memory computation circuit used by system of Figure 6.

DETAILED DESCRIPTION

Like features have been designated by like references in the various figures. In particular, the structural and/or functional features that are common among the various embodiments have the same references and have identical structural, dimensional and material properties.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following description, when reference is made to terms qualifying absolute positions, such as terms "front", "rear", "top", "bottom", "left", "right", etc., or relative positions, such as terms "above", "under", "upper", "lower", "over", etc., or to terms qualifying directions, such as terms "horizontal", "vertical", etc., unless specified otherwise, it is referred to the orientation of the drawings.

Reference is made to Figure 2 showing the basic structure of a PCM cell 110 implemented in an integrated circuit. A semiconductor substrate 112 includes a transistor 114 comprised of an insulated gate 116 extending over a channel region 118 between a doped source region 120 and a doped drain region 122. The substrate 112 is covered by a layer 124 of dielectric material. A contact plug 126, for example, made of tungsten, extends through the layer 124 to make electrical connection to the drain region 122 (perhaps using a suitable silicide interface). A heater element 130 for the PCM cell 110 is provided in an insulating layer 132 extending over the layer 124. This insulating layer 132 is, for example, a part of a first metallization layer (M1) of the integrated circuit. The heater element 130 is made of a conformal layer of an electrically conductive material (deposited, for example, using an atomic layer deposition (ALD) process) that is lithographically patterned in the form of an L-shape cross-section including a horizontal portion 130a in contact with the upper surface of the contact plug 126 and a vertical portion 130b extending on a side edge of the insulating layer 132. Thicknesses of the conformal layer of electrically conductive material for heater element 130 in the horizontal portion 130a and the vertical portion 130b are substantially equal to each other. In one embodiment, the thicknesses of the conformal layer of electrically conductive material for heater element 130 in the horizontal portion 130a and the vertical portion 130b are identical to each another, In another embodiment, the thicknesses of the conformal layer of electrically conductive material for heater element 130 in the horizontal portion 130a and the vertical portion 130b have a difference of no more than $\pm 5\%$ centered on a nominal thickness, wherein the nominal thickness is in particular defined by design.

The electrically conductive material for heater element 130 is well suited to heat the chalcogenic material by the Joule effect in response to the flow of a programming current. In particular, the electrically conductive material of the heater element 130 has an activated resistance in temperature. In this context, an electrically conductive material for the heater of the PCM cell exhibiting an "activated resistance in temperature" means that the material has a first resistance at first (for example, a low or relatively lower) temperature and a second resistance, less than the first resistance, at a second (for example, high or relatively higher) temperature. Examples of such an activated resistance in temperature electrically conductive material for the heater element 130 are discussed in detail herein. A region 140 of chalcogenic material (made of a selected GST alloy, for example) is provided over the layer 132 and in contact with a distal end of the vertical portion 130b of the heater element 130. The region 140 is surrounded, in a non-limiting example, by a layer 144 of insulating material. A second metallization layer (M2) of the integrated circuit includes a metal line 150 electrically connected to the region 40 of chalcogenic material by a via 152. The PCM cell 110 can further comprise an electrically conductive lamina 134 interposed between the vertical portion 130b of the heater element 130 and the underside of the region 140. The lamina 134 can be made of the same electrically conductive material as the heater element 130 (i.e., it also can exhibit an activated resistance in temperature), or be made of a different electrically conductive material such as a refractory metal or a refractory metal nitride (examples of which include, without limitation, titanium nitride, tantalum, tantalum nitride and tungsten).

The insulated gate 116 of transistor 114 is configured to receive a control signal generated by control circuit to operation as a current generator. The control signal is set by the control circuit to accurately control the pulse of current flowing through the PCM cell 110 depending on operating mode. This is critical because the heater element 130 exhibits the activated resistance in temperature and thus it exhibits different resistivities when the current pulse is a programming pulse current and when the current pulse is a reading current pulse. For example, a gate voltage in a range of 2.5 to 2.7 Volts provides current levels of 320 $\mu$A and 360 $\mu$A, respectively.

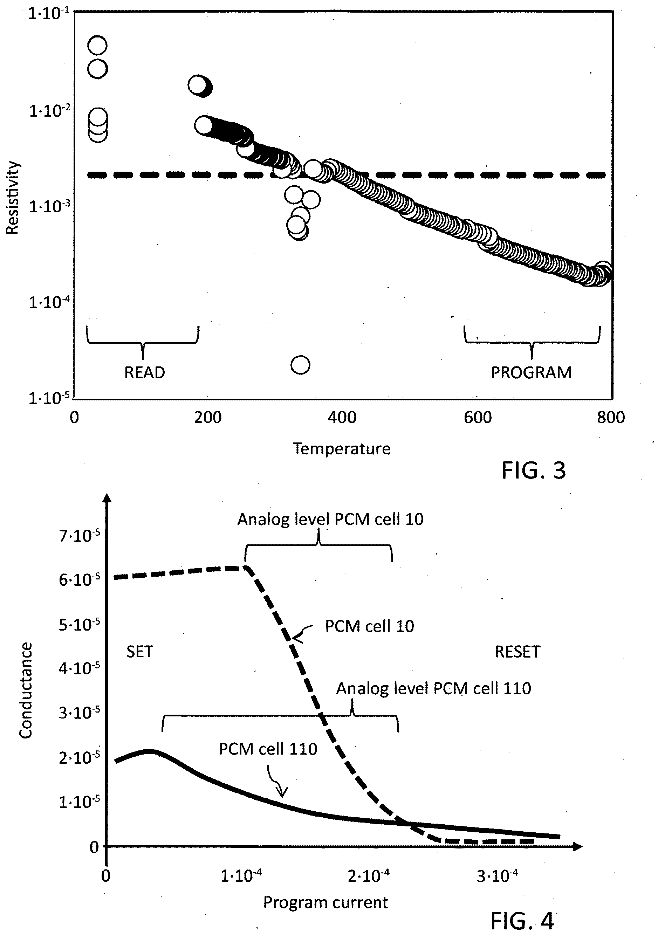

Reference is now made to Figure 3 which shows a plot of resistivity (in $\Omega$ cm) versus temperature (in degrees Centigrade) for the conductive material used for the heater element 30, 130 in the PCM cell 10, 110 of Figures 1 and 2. For reference purposes, the dotted line represents the resistivity as a function of temperature for a conventional conductive material (such as TiSiN) as used for the heater element 30 in the PCM cell 10 of Figure 1. It will be noted that the resistivity of such a conventional conductive material is substantially constant over a wide range of temperature from 0 to 800 °C (in other words, this material exhibits a stable resistivity in temperature). Because of this, the resistivity of the conductive material for the heater element 30 is substantially the same in both the temperature range within which read operations for the PCM cell occur and the temperature range within which programming operations for the PCM cell occur. The circles represent the resistivity as a function of temperature for the activated resistance in temperature conductive material used for the heater element 130 in the PCM cell 110 of Figure 2. It will be noted that the resistivity of such an activated resistance in temperature conductive material exhibits a slope over a wide range of temperature from 0 to 800 °C (in other words, this material does not exhibit a stable resistivity in temperature). More particularly, the slope is negative with increase in temperature, and thus the resistivity of the conductive material for the heater element 130 is relatively higher (over a first resistance range) in the lower temperature range within which read operations for the PCM cell occur and relatively lower (over a second resistance range lower than the first resistance range) in the higher temperature range within which programming operations for the PCM cell occur. Specifically, the resistivity range of the conductive material for the heater element 130 in the lower temperature range within which read operations for the PCM cell occur is higher than the resistivity range of the conventional conductive material (used for the heater element 30) over that same temperature range. Because of this, the PCM cell 110 will exhibit a higher conductance in the set state as compared to the PCM cell 10. Also, the resistivity range of the conductive material for the heater element 130 in the higher temperature range within which programming operations for the PCM cell occur is lower than the resistivity range of the conventional conductive material (used for the heater element 30) over that same temperature range.

Reference is now made to Figure 4 which shows a plot of conductance (in S) versus program current (in Amps) for the PCM cell 10, 110. For reference purposes, the dotted line represents the conductance as a function of program current for the PCM cell 10 of Figure 1 using the conventional conductive material (such as TiSiN) for the heater element 30. The solid line represents the conductance as a function of program current for the PCM cell 110 of Figure 2 using the activated resistance in temperature conductive material for the heater element 130. It will be noted that the conductance (approximately 20 $\mu$S) of the PCM cell 110 is higher than the conductance (approximately 60 $\mu$S) of the PCM cell 10 in the set state (LRS), and thus will exhibit an improved performance in terms of the TOPS/W metric. Additionally, the PCM cell 110 has a wider analog level range than the PCM 10 with a smooth transition between the low resistive state and high resistive state, and thus presents an improved data storage cell for analog levels that are used for programmed data in IMC applications.

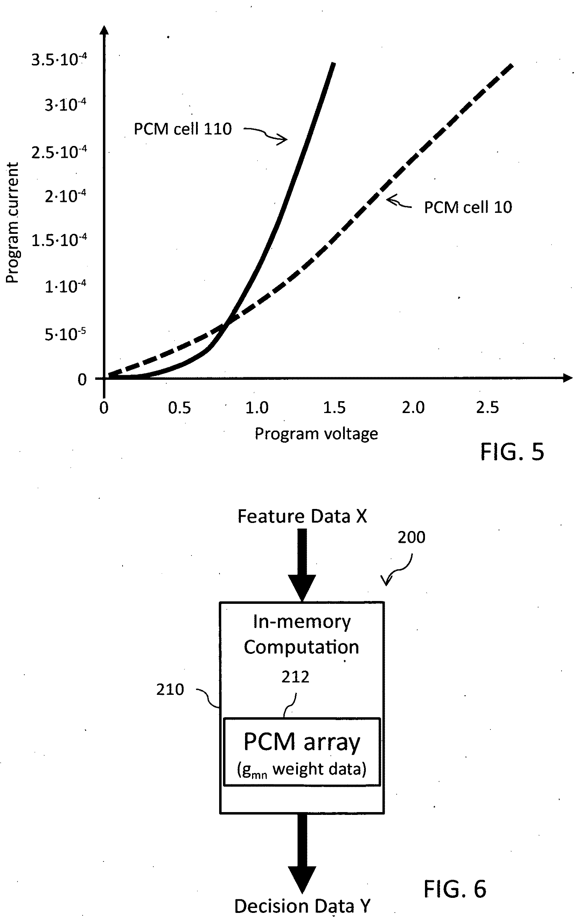

Reference is now made to Figure 5 which shows a plot of program current (in Amps) versus program voltage (in Volts) for the PCM cell 10, 110. For reference purposes, the dotted line represents the program current as a function of program voltage for the PCM cell 10 of Figure 1 using the conventional conductive material (such as TiSiN) for the heater element 30. The solid line represents the program current as a function of program voltage for the PCM cell 110 of Figure 2 using the activated resistance in temperature conductive material for the heater element 130. It will be noted that with the use of the activated resistance in temperature conductive material, the heater element 130 which exhibits a lower resistance at the higher temperatures associated with performing the programming operation (see, also, right side of Figure 3).

As an example, the activated resistance in temperature conductive material for the heater element 130 has a resistivity in the range of $1\cdot10^{-2}$ to $1\cdot10^{-1}$ $\Omega$cm over a lower temperature range of 0 to 100 °C (associated with operation in read mode), and a resistivity in the range of $1\cdot10^{-4}$ to $1\cdot10^{-3}$ $\Omega$cm over a higher temperature range of greater than 500 °C (associated with operation in program mode).

In an embodiment, the activated resistance in temperature electrically conductive material for the heater element 130 comprises a material based on TiSiN but with a specific stoichiometry percentage that enables the material to exhibit the desired activated resistance in temperature properties noted above. Specifically, the TiSiN material used for heater element 130 has a silicon content in the range of 14-19% (more preferably at or about 16.5%). Additionally, the TiSiN material used for heater element 130: a) is substantially free of carbon (in this context substantially free means a carbon content less than 1%, preferably <0.5%, and more preferably no carbon presence at all - noting, however, unavoidable or tolerable very small traces of carbon can be present and attributable to one or more causes such as: environmental contamination, intrinsic impurity of raw materials used in the process of making, impurities derived from the use of certain tools or machinery during the production and treatment of the material, etc., but the presence of such traces of carbon do not introduce a substantial change in electrical properties (for example, resistance, conductivity, etc.) of the conductive material in comparison to a wholly carbon-free material); b) has a nitrogen content in the range of 40-60% (more preferably in the range of 45-55%, and even more specifically at or about 50%); c) has an oxygen content in the range of 0-2% (the oxygen comprising, for example, a contaminant due to the process of producing the TiSiN material for the heater element); and/or d) a titanium content in the range of 25-40% (more preferably 30-37%). Other elements in small trace content amounts (<1%) can be present and attributable to the processing operation without having an effect on the noted activated resistance in temperature property of the TiSiN conductive material.

In a preferred embodiment, an example TiSiN stoichiometry (based on percentage) for a conductive material having activated resistance in temperature that is well suited for use as the heater element 130 for the PCM cell 110 of Figure 2 would include the following content percentages: 29.7% Ti, 52% N, 16.5% Si, 1.1% O and 0.4% Cl. While specific content percentages are provided with this example, it will be understood that some variation in the content percentages (for example, plus minus 1-3%) may be acceptable while still providing the desired activated resistance in temperature. Such variation in content percentage may further be a result in process variation during manufacture. In any case, the noted acceptable variation in content percentage will not adversely influence the desired activated resistance in temperature property of the conductive material for heater element 130.

The Inventors understand that the noted content percentage of silicon in the TiSiN electrically conductive material having activated resistance in temperature (for example, with a silicon content in the range of 14-19%, more preferably at or about 16.5%) appears to be an important driver in obtaining the conductive material whose resistance is relatively higher (for example, in the range of $1 \cdot 10^{-2}$ to $1 \cdot 10^{-1}$ $\Omega$cm) over the lower temperature range of 0 to 150 °C, preferably at about 100 °C which is associated with operation of the PCM cell 110 during data read, and relatively lower (for example, in the range of $1 \cdot 10^{-4}$ to $1 \cdot 10^{-3}$ $\Omega$cm) over the higher temperature range of greater than 400 °C, preferably greater than 500 °C, which is associated with operation of the PCM cell 110 during data write (programming).

In a preferred implementation of the fabrication of the PCM cell 110, an atomic layer deposition (ALD) process is used to conformally deposit the layer of the TiSiN electrically conductive material having activated resistance in temperature. As an example, a thickness of about 30Å (plus minus 1-3%) is preferred to limit Q time issue versus oxidation. That layer of TiSiN electrically conductive material having activated resistance in temperature is then further processed, for example using conventional semiconductor processing techniques (such as, for example, lithographic patterning, etching, polishing, etc.), to define the size and shape of the heater element 130. In the case of use of the lamina 134 (see, Figure 2) over the heater element 130 when made of the same TiSiN electrically conductive material having activated resistance in temperature as the heater element 130, a further ALD deposition step using the same process parameters with subsequent semiconductor processing techniques is used to produce the lamina 134.

The following provides a non-limiting example of the ALD process used to produce the layer of the TiSiN conductive material having activated resistance in temperature: Deposition temperature: 440°C; Deposition process: $6TiCl_4 + 8NH_3 \rightarrow 6TiN + 24HCl + N_2$; with N number of cycles (where N = 31, for example), with each cycle depositing a layer with a thickness of about 1Å; $SiH_4$ flux of 150sccm. The deposition occurs as follows, with steps 2 through 5 being repeated N times: Step 1 $\rightarrow$ $TiCl_4$ flow and chemisorption, Step 2 $\rightarrow$ Purging to flush gas phase reactants, Step 3 $\rightarrow$ $NH_3$ flow and surface reaction, Step 4 $\rightarrow$ Purging and TiN formation, Step 5 $\rightarrow$ $SiH_4$ adsorption on TiN layer, Step 6 $\rightarrow$ Purging and $SiH_4$ reacts with TiN, Step 7 $\rightarrow$ $TiCl_4$ adsorption on TiSiN later, Step 8 $\rightarrow$ TiSiN film is obtained after multiple cycles of Step 2 through Step 7.

Reference is now made to Figure 6 which shows a basic block diagram for an in-memory computation (IMC) system 200. The IMC system 200 includes an in-memory computation circuit 210 having a memory array 212 including an array of bit cells storing information and performing calculations at the bit cell level. An example of a calculation performed by the IMC circuit 210 is a multiply and accumulate (MAC) operation where an input array of numbers (X values, also referred to as the feature or coefficient data) are multiplied by an array of computational weights (g values) stored in the memory and the products are added together to produce an output array of numbers (Y values, also referred to as the decision data).

$$\begin{bmatrix} Y_1 \\ Y_2 \\ \vdots \\ Y_m \end{bmatrix} = \begin{bmatrix} g_{11} & g_{12} & \cdots & g_{1n} \\ g_{21} & g_{22} & \cdots & g_{2n} \\ \vdots & \vdots & \vdots & \vdots \\ g_{m1} & g_{m2} & \cdots & g_{mn} \end{bmatrix} \times \begin{bmatrix} X_1 \\ X_2 \\ \vdots \\ X_n \end{bmatrix}$$

$$\begin{cases} Y_1 = g_{11} \times X_1 + g_{12} \times X_2 + \cdots + g_{1n} \times X_n \\ Y_2 = g_{21} \times X_1 + g_{22} \times X_2 + \cdots + g_{2n} \times X_n \\ \qquad\qquad\qquad \vdots \\ Y_m = g_{m1} \times X_1 + g_{m2} \times X_2 + \cdots + g_{mn} \times X_n \end{cases}$$

By performing these calculations at the bit cell level in the memory, the IMC circuit 210 does not need to move data back and forth between a memory device and a computing device. Thus, the limitations associated with data transfer bandwidth between devices are obviated and the computation can be performed with lower power consumption.

The memory array 212 of the IMC circuit 210 is implemented using phase change memory (PCM) cells (such as the PCM cells 110 shown in Figure 2). The PCM cell 110 is configured to store the weight data using a phase change material that is capable of stably transitioning between amorphous and crystalline phases according to an amount of heat transferred thereto. The amorphous and crystalline phases exhibit two or more distinct resistances, in other words two or more distinct conductances, which are used to distinguish two (for binary data) or more (for m-ary data, m being an integer greater than or equal to three) distinct logic states programmable into the memory cell. The amorphous phase exhibits a relatively higher resistance (i.e., a lower conductance) and thus the current flowing through the memory cell programmed in this set state when selected is relatively smaller. Conversely, the crystalline phase exhibits a relatively lower resistance (i.e., a higher conductance) and thus the current flowing through the memory cell programmed in this reset state is relatively larger.

The phase change material used in a PCM cell typically utilizes germanium (Ge) along with chemical elements of Group VI of the Periodic Table of the Elements such as tellurium (Te), selenium (Se), and/or antimony (Sb) which are referred to in the art as chalcogenides or chalcogenic materials. For example, the phase change material can comprise a $Ge_xSb_yTe_z$ alloy (referred to in the art as a GST alloy).

The phase change memory (PCM) array 212 is configured to store the computational weights ($g_{mn}$ weight data) for the in-memory computation operation. The in-memory computation process performed by the circuit 210 receives an input array of numbers referred to as the feature (or coefficient) data X which are matrix vector multiplied (MVM) by the array of the stored computational weight data $g_{mn}$ to produce an output array of numbers referred to as the decision data Y.

The PCM cells 110 within the array 212 utilize a specific GST alloy for the phase change material that is selected for its suitability to support implementation of a rheostatic memory cell. By this it is meant that the PCM cells 110 within the array 212 are capable of storing m-ary (where m is an integer greater than or equal to three) logic states. In other words, the amorphous and crystalline phases of the phase change material of each PCM cell 110 in the array 212 can be programmed to exhibit three or more distinct resistances with a corresponding three or more distinct conductances (see, for example, Figure 4 and the analog level range for cell 110).

In a preferred implementation, the GST alloy used for layer 140 in each PCM cell 110 is a stoichiometric GST alloy such as the GST 225 alloy ($Ge_2Sb_2Te_5$) or the GST 447 alloy ($Ge_4Sb_4Te_7$). It will be understood, however, that another GST alloy could instead be selected based on the application.

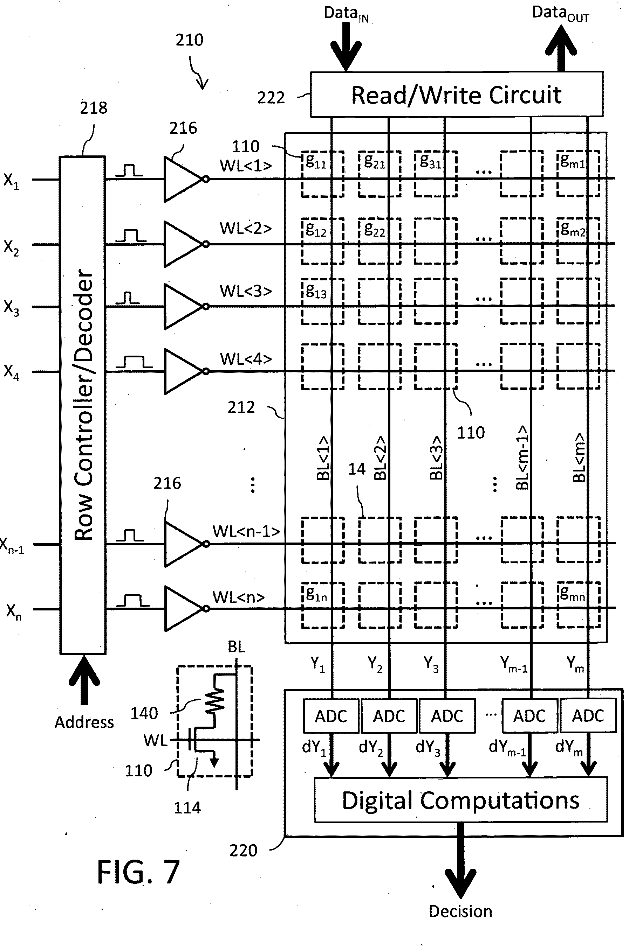

Reference is made to Figure 7 which shows a schematic diagram of an example for the in-memory computation circuit 210 used by system 200 of Figure 6. The circuit 210 utilizes a memory array 212 formed by a plurality of memory cells 110 arranged in a matrix format having m columns and n rows. Each memory cell 110 is programmed to store a bit of data $g_{ab}$, where a is an integer from 1 to m and b is an integer from 1 to n, relating to the computational weights (also referred to as kernel data) for an in-memory compute operation. Each bit of the computational weight has an m-ary logic value (where m is an integer greater than or equal to three) which is represented, for example, by a programmable transconductance in the memory cell 110.

In an embodiment of the memory array 212, each memory cell 110 comprises a phase change memory (PCM) cell formed by a select circuit (MOSFET transistor) 114 (see, also transistor 114 of Figure 2) operating as a switching element and a variable resistive element 140 (see, also phase change material layer 140 of Figure 2) providing a programmable conductance. The control node (gate) of the MOSFET transistor select circuit 114 is connected to the word line WL. The source-drain conduction path of the MOSFET transistor switching element 114 is connected in series with the variable resistive element 140 between the bit line BL and a reference node (for example, a source line or ground).

The PCM-type memory cell 110 is a rheostatic cell configured to store the weight data using a phase change material. The phase change material is a chalcogenide in the form of a first GST alloy such as a stoichiometric GST alloy such as, for example, the GST 225 alloy ($Ge_2Sb_2Te_5$) or the GST 447 alloy ($Ge_4Sb_4Te_7$).

Each memory cell 110 includes a word line WL and a bit line BL. The memory cells 110 in a common row of the matrix are connected to each other through a common word line WL<b>. The memory cells 110 in a common column of the matrix are connected to each other through a common bit line BL<a>.

Each word line WL<b> is driven by a word line driver circuit 216 with a pulsed word line signal generated by a row controller/decoder circuit 218. The word line driver circuit 216 can be implemented as a CMOS driver circuit (for example, a series connected p-channel and n-channel MOSFET transistor pair forming a logic inverter circuit).

The row controller/decoder circuit 218 receives an address signal (Address) for the in-memory compute operation and in response thereto performs the function of selecting which plural ones of the word lines WL<1> to WL<n> are to be simultaneously accessed (or actuated) in parallel during an analog in-memory compute operation. The row controller/decoder circuit 218 further receives the feature or coefficient data $X_b$ for the in-memory compute operation and in response thereto controls, for each corresponding actuated word line WL<b>, the width (i.e., the on time $T_{ON}$) of the generated pulsed word line signal. This functionality is a form of a pulse width modulation (PWM) control for the applied word line signals dependent on the digital value of the received feature or coefficient data X.

Figure 7 illustrates, by way of example only, the simultaneous actuation of all word lines WL<1>, ..., WL<n> in response to the received Address with pulsed word line signals having pulse widths set by the digital value of the corresponding coefficient data $X_1$, ..., $X_n$. It will, of course, be understood that the in-memory compute operation can instead utilize a simultaneous actuation of fewer than all rows of the memory array (through either Address signal selection or through a zero value for a given coefficient data $X_b$).

The analog signal $Y_a$ developed on the bit line BL<a> is dependent on the logic state of the bits of the computational weight $g_{ab}$ stored in the b=1 to n memory cells 110 of the column and the widths of the pulsed word line signals applied to the word lines WL<1>, ..., WL<n> for those memory cells 110. More specifically, it will be understood that each memory cell 110 contributes a bit line BL discharge current that is proportional to $X_b \times g_{ap}$. So, in the example shown in Figure 7 where the word line signals are simultaneously applied to the word lines WL<1>, ..., WL<n>, the analog signal $Y_1$ developed on the bit line BL<1> is proportional to the sum of discharge currents due to $X_1 \times g_{11}$, $X_2 \times g_{12}$, ..., and $X_n \times g_{1n}$.

A column processing circuit 220 senses and samples the analog signal $Y_a$ on each bit line BL<a> for the m columns and converts the analog signal to a corresponding digital signal $dY_a$ using analog-to-digital converter circuitry. Although Figure 7 illustrates that one analog-to-digital converter (ADC) is provided for each column, it will be understood that ADC resources in the column processing circuit 220 could instead be shared by multiple columns using time division multiplexing. The column processing circuit 220 can further include digital signal processing circuitry for performing digital computations and calculations on the digital signals $dY_a$ to generate a decision output for the in-memory compute operation.

The circuit 210 for the IMC system 200 further includes a read-write circuit 222 that operates in conjunction with the row controller/decoder circuit 218 in connection with memory access operations to write bits of data (for example, the computational weight data) to, and read bits of data from, the memory cells 110 of the memory array 212 according to the applied Address (see, $Data_{IN}$ and $Data_{OUT}$ busses coupled to read-write circuit 222). This operation is referred to as a conventional memory access mode and is distinguished from the analog in-memory compute operation discussed above. Operation in the conventional memory access mode to write data into the memory cells 110 of the memory array 212 is performed in connection with performing a data load or a data refresh operation.

The configuration of the in-memory computation circuit 210 shown in Figure 7 is just one example of an in-memory computation circuit 210 suitable for use in the IMC system 200 of Figure 6. The Figure 7 example for the in-memory computation circuit 210 is to be understood as a non-limiting example. Those skilled in the art are well-aware of other configurations for in-memory computation circuits 210 that could instead be used for the IMC system 200. What is important to note, no matter what in-memory computation circuit 210 configuration is employed, is that the memory cells 110 of the memory array 212 are implemented as rheostatic phase change memory cells using a stoichiometric GST alloy for the phase change material layer 140 and a heater element 130 having activated resistance in temperature as discussed above.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

**Claims**

1. A phase change memory, PCM, cell (110), comprising:

   a phase change material region (140); and
   a heater element (130) coupled to phase change material region (140);
   wherein the heater element (130) comprises a layer of an electrically conductive material having an activated resistance in temperature property; and
   wherein the electrically conductive material of said layer of the heater element (130) is an alloy having a silicon content in a range of 14-19%.

2. The PCM cell of claim 1, wherein the activated resistance in temperature property of the electrically conductive material means that the heater element (130) has a resistance in a first resistance range when the electrically conductive material is at a temperature within a first temperature range associated with a reading operation of the PCM cell (10)and has a resistance in a second resistance range, different and lower than the first resistance range, when the electrically conductive material is at a temperature within a second temperature range, different and higher than the first temperature range, associated with programming operation of the PCM cell (10).

3. The PCM cell of claim 2, wherein a maximum value of the first temperature range is less than 150°C and wherein a minimum value of the second temperature range is greater than 400°C.

4. The PCM cell of claim 2 or 3, wherein the first resistance range is in a range of $1 \cdot 10^{-2}$ to $1 \cdot 10^{-1}$ $\Omega$cm and the second

resistance range is in a range of $1 \cdot 10^{-4}$ to $1 \cdot 10^{-3}$ $\Omega$cm.

5. The PCM cell of anyone of the preceding claims, wherein the alloy of the electrically conductive material is substantially free of carbon, in particular the alloy of the electrically conductive material has a carbon content less than 1%.

6. The PCM cell of anyone of the preceding claims, wherein the alloy is a titanium silicon nitride alloy having:

   a nitrogen content in a range of 40-60%; and
   a titanium content in a range of 25-40%.

7. The PCM cell of anyone of the preceding claims, wherein the layer of electrically conductive material has a horizontal layer portion having a first thickness and a vertical layer portion having a second thickness, wherein the first and second thicknesses are substantially equal, in particular wherein the first and second thicknesses are identical or have a difference of no more than $\pm 5\%$ of a nominal thickness.

8. The PCM cell of anyone of the preceding claims, wherein the layer of electrically conductive material is a conformal layer, in particular produced by atomic layer deposition.

9. The PCM cell of anyone of the preceding claims, wherein phase change material region is made of a germanium-antimony-tellurium, GST, alloy.

10. The PCM cell of claim 9, wherein the GST alloy is germanium rich having a stoichiometric percentage of germanium in excess of 50%.

11. An in-memory computation, IMC, device (200), comprising a memory array (212) including a plurality of PCM cells (10) according to anyone of claims 1-10.

12. A method of making a phase change memory, PCM, cell (110), comprising:

   producing a heater element (130); and
   producing a phase change material region (140) over the heater element (130);
   wherein producing the heater element (130) comprises forming a layer of an electrically conductive material having an activated resistance in temperature property;
   wherein the electrically conductive material of the heater element is an alloy having a silicon content in a range of 14-19%.

13. The method of claim 12, wherein the activated resistance in temperature property of the electrically conductive material means that the heater element (130) has a resistance in a first resistance range when the electrically conductive material is at a temperature within a first temperature range associated with a reading operation of the PCM cell and has a resistance in a second resistance range, different and lower than the first resistance range, when the electrically conductive material is at a temperature within a second temperature range, different and higher than the first temperature range, associated with a programming operation of the PCM cell.

14. The method of claim 13, wherein a maximum value of the first temperature range is less than 150°C and a minimum value of the second temperature range is greater than 400°C.

15. The method of anyone of claims 12-14, wherein forming said layer of electrically| conductive material comprises depositing a conformal layer by atomic layer deposition.

FIG. 1

FIG. 2

FIG. 3

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10510955 B
- US 11227992 B
- US 11653582 B